# EUROPEAN PATENT APPLICATION

(11) **EP 4 462 577 A1**
(43) Date of publication of application: **13.11.2024**
(21) Application number: 23382451.5
(22) Date of filing: 12.05.2023
(51) Int. Cl.: H01M 50/308, H01M 50/333, H01M 50/30, H05K 5/02

(54) **VENTING UNIT FOR VENTING ELECTRONICS HOUSING**

(71) Applicant: MANN+HUMMEL GmbH, 71636 Ludwigsburg (DE)
(72) Inventor: RODRIGO, Jorge, 50011 Zaragoza (ES); OLIVAN, Juan Jose, 50008 Zaragoza (ES); MARZAL LOPEZ, Leopoldo, 50019 Zaragoza (ES); LORENTE, Sonia, 50006 Zaragoza (ES); GRIECO, Giovanni, 50014 Zaragoza (ES)
(74) Representative: Mann + Hummel Intellectual Property

(57) **Abstract**

A venting unit (100) for venting an electronics housing includes a base body (10) configured to be connected to a pressure compensation opening of the electronics housing, a fluid-permeable cover (40) disposed on the base body (10) and a valve closure plate (70) covering an opening (12) of the base body (10) and being covered by the cover (40). The venting unit (100) further includes a spring member (90) interposed between the valve closure plate (70) and the cover (40) and engaging the valve closure plate (70) and the cover (40). The cover (40) has at least two mounting positions (44, 46, 48) providing different heights (84, 86, 88) of the cover (40) above the valve closure plate (70). A pre-compression of the spring member (90) corresponding to an opening pressure of the valve closure plate (70) is controlled by an actual mounting position of the cover (40).

## Description

### Technical Field

The invention relates to a venting unit for venting an electronics housing, in particular a battery housing.

### Background Art

CN208298911 U discloses a gas venting valve comprising an elastic sealing cover, a main body, a gas permeable membrane, a connecting post, a sealing ring and a bottom cover. The elastic sealing cover is fixedly engaged at one end of the main body, and the other end of the main body has a cylinder. The gas permeable membrane is welded to one end of the connecting post near the main body. The sealing ring is sleeved on one end of the connecting post near the gas permeable membrane. The connecting post is engaged with the main body cylinder. On the inner layer, the bottom cover is snapped onto the outer layer of the main body cylinder. The venting valve further includes an elastic member, one end of the elastic member abutting the bottom cover, and the other end abutting against an end of the connecting post away from the gas permeable membrane.

### Summary

It is an object of the invention to provide an improved venting unit for venting an electronics housing, in particular a battery housing.

According to an aspect of the invention, the object is achieved by a venting unit for venting an electronics housing, in particular a battery housing, comprising a base body configured to be connected to a pressure compensation opening of the electronics housing, a fluid-permeable cover disposed on the base body, a valve closure plate covering an opening of the base body and being covered by the cover, and a spring member interposed between the valve closure plate and the cover and engaging the valve closure plate and the cover. The cover has at least two mounting positions providing different heights of the cover above the valve closure plate, and a pre-compression of the spring member corresponding to an opening pressure of the valve closure plate is controlled by the actual mounting position of the cover.

Advantageous embodiments are described in the dependent claims, the description and the drawings.

According to an aspect of the invention, a venting unit for venting an electronics housing, in particular a battery housing, is proposed, comprising a base body configured to be connected to a pressure compensation opening of the electronics housing, a fluid-permeable cover disposed on the base body, and a valve closure plate covering an opening of the base body and being covered by the cover. A spring member is interposed between the valve closure plate and the cover engaging the valve closure plate and the cover. The cover has at least two mounting positions providing different heights of the cover above the valve closure plate. A pre-compression of the spring member corresponding to an opening pressure of the valve closure plate is controlled by an actual mounting position of the cover.

The proposed venting unit comprises a gas passage opening for venting the electronics housing it is mounted to. The gas passage opening is under normal conditions closed by the valve closure plate being pressed against a sealing in a fluid-tight manner, the sealing being disposed, e.g., on a circumference of the gas passage opening. The venting unit further comprises a spring member being interposed between the cover and the valve closure plate thus ensuring the tight closure with the compression load of the spring member.

Advantageously, in the proposed venting unit the spring member provides an opening pressure of the valve closure plate which is adjustable according to a mounting position of the cover of the venting unit with respect to the base body. The cover and the valve closure plate are designed in a way that, depending on the relative assembly condition between both parts the spring member, is set to different compression loads and, therefore, the opening pressure of the valve closure plate varies in the different mounting positions. The compression load is depending on the length of the spring member according to its spring constant. The length of the spring member hereby may be determined by the height of the cover above the valve closure plate depending on the different mounting positions of the cover relative to the base body.

Thus, advantageously, the opening pressure of the venting unit may be customized depending on customer needs. Different opening pressures of the valve closure plate may be adjusted during the manufacturing process of the venting unit. Once adjusted to the desired opening pressure of the venting unit the cover may be fixed to the base body so that the opening pressure may not be changed. This may be achieved by a design where the fixing elements of a snap connection between the cover and the base body are hidden to the customer.

Alternatively it is also possible that the design of the venting unit is such that the opening pressure may be changed by changing the mounting position of the cover relative to the base body even after the manufacturing process.

Advantageously, venting of the electronics housing to the environment is possible through one or more openings in the cover.

According to a favorable embodiment of the venting unit, the at least two mounting positions may be angular positions around a central axis. Thus the cover may be rotated around the central axis and fixed in the different angular positions in order to change the height of the cover above the base body and by this way above the valve closure plate. By this way the compression load of the spring member may be adjusted according to the needs.

According to a favorable embodiment of the venting unit, the at least two mounting positions may be secured by a snap connection between the cover and the base body. Thus easy mounting of the cover in the different mounting positions may be achieved. Once the cover is fixed to the base body the position of the cover may not be changed any longer.

According to a favorable embodiment of the venting unit, one end of the spring member may be disposed in a recess disposed at an inner side of the cover, and another end of the spring member may be disposed on a guiding element of the valve closure plate. By this way a proper guiding of the spring member during adjustment of the height of the cover above the valve closure plate by rotation of the cover around the central axis may be guaranteed.

Favorably, a rotationally symmetric design for proper functioning of the adjustment of the height of the cover above the valve closure plate and therefore the spring compression load may be chosen.

According to a favorable embodiment of the venting unit, the snap connection may comprise at least one fixing element at the cover counteracting with a first one and/or a second one of at least two counter elements at the base body for fixing the cover in a first one and/or a second one of the at least two mounting positions at the base body. In particular, the at least one fixing element may be a latching element on a circumference of the cover and the at least two counter elements are holes in a rim of the base body. Thus easy mounting of the cover in the different mounting positions may be achieved. Once the cover is fixed to the base body the position of the cover may not be changed any longer.

According to a favorable embodiment of the venting unit, two fixing elements may be disposed across each other on a circumference of the cover, and two corresponding counter elements are disposed across each other on a rim of the base body. A symmetric design with at least two opposing engaging fixing elements may ensure proper and reproducible functioning of the adjustment of the spring compression load.

According to a favorable embodiment of the venting unit, the latching element may comprise a pin counteracting with a spring supported at the circumference of the cover. Such a latching element may facilitate a reliable and reproducible mounting of the cover in the at least two mounting positions for adjusting the spring compression load.

According to a favorable embodiment of the venting unit, the rim of the base body may be a circumferential groove, and the circumference of the cover may be received by the circumferential groove in an intended mounting position. Thus, a proper receiving position of the cover within the base body at different heights of the cover may be realized.

According to a favorable embodiment of the venting unit, the counter elements may be disposed on an inner side of the circumferential groove, and the fixing element disposed on the circumference of the cover may be pointing radially inwards. Advantageously, the fixing elements may be hidden on an inner side of the circumferential groove for being inaccessible after completion of the manufacturing process of the venting unit.

According to a favorable embodiment of the venting unit, the cover may be connected to the base body by a circumferential thread counteracting with a thread engagement region of a rim of the base body. With such an embodiment different mounting positions of the cover relative to the base body may be achieved by simply changing the engagement of the threading. Mounting of the cover to the base body may advantageously be facilitated without additional mounting elements.

According to a favorable embodiment of the venting unit, the cover may be disposed in a plurality of angular positions around the central axis, and the plurality of angular positions may be realized by a variation of a depth of threading the circumferential thread of the cover into the thread engagement region of the base body. With such an embodiment different mounting positions of the cover relative to the base body may be achieved by simply changing the engagement of the threading.

According to a favorable embodiment of the venting unit, the cover may be fixed to the base body after being disposed in an intended angular position. In particular, the cover may be fixed to the base body after being disposed in the intended angular position by a poka-yoke or any kind of fixation between the cover and the rim of the base body. By fixing the cover to the base body the actual height of the cover above the base body and thus above the valve closure plate may be frozen and may not be changed after the manufacturing process, in particular, not by the customer.

According to a favorable embodiment of the venting unit, the valve closure plate may have at least one plate opening, and in particular may include a grid-like element covering the at least one plate opening. The venting unit may further include a semipermeable membrane covering the at least one plate opening and enabling passage of gaseous media from an environment into the electronics housing and from the electronics housing to the environment, but preventing passage of liquid media and solids. By this way a normal venting for balancing different atmospheric pressures between the environment and the electronics housing the venting unit is mounted to may be ensured without opening the valve closure plate. Thus, intrusion of dust particles, e.g., during venting, may be avoided. Favorably, the valve closure plate may open the gas passage opening when a higher pressure occurs inside the electronics housing.

### Brief Description of Drawings

The present invention together with the above-mentioned and other objects and advantages may best be understood from the following detailed description of the embodiments, but not restricted to the embodiments, wherein:
Figure 1 is an isometric view of a venting unit for venting an electronics housing, in particular a battery housing, according to an embodiment of the invention;
Figure 2 is an isometric view of part of the venting unit in a first mounting position of the cover;
Figure 3 is a partly cut isometric view of the venting unit;
Figure 4 is a partly cut isometric view of a venting unit according to a further embodiment of the invention with an opening in the valve closure plate;
Figure 5 is a top view of the venting unit according to Fig. 4;
Figure 6 is a sectional cut of the venting unit according to the section plane A-A of Fig. 5;
Figure 7 is a detail of the sectional view of Fig. 6;
Figure 8 is an isometric view of part of the venting unit in a second mounting position of the cover;
Figure 9 is a top view of the venting unit according to Fig. 8;
Figure 10 is a sectional cut of the venting unit according to the section plane B-B of Fig. 9;
Figure 11 is an isometric view of the venting unit with part of the base body removed in the first mounting position of the cover;
Figure 12 is an isometric view of the venting unit with part of the base body removed in the second mounting position of the cover;
Figure 13 is a venting unit according to a further embodiment of the invention;
Figure 14 is a top view of the venting unit according to Fig. 13; and
Figure 15 is a sectional cut of the venting unit according to the section plane C-C of Fig. 14.

### Detailed Description

In the drawings, like elements are referred to with equal reference numerals. The drawings are merely schematic representations, not intended to portray specific parameters of the invention. Moreover, the drawings are intended to depict only typical embodiments of the invention and therefore should not be considered as limiting the scope of the invention.

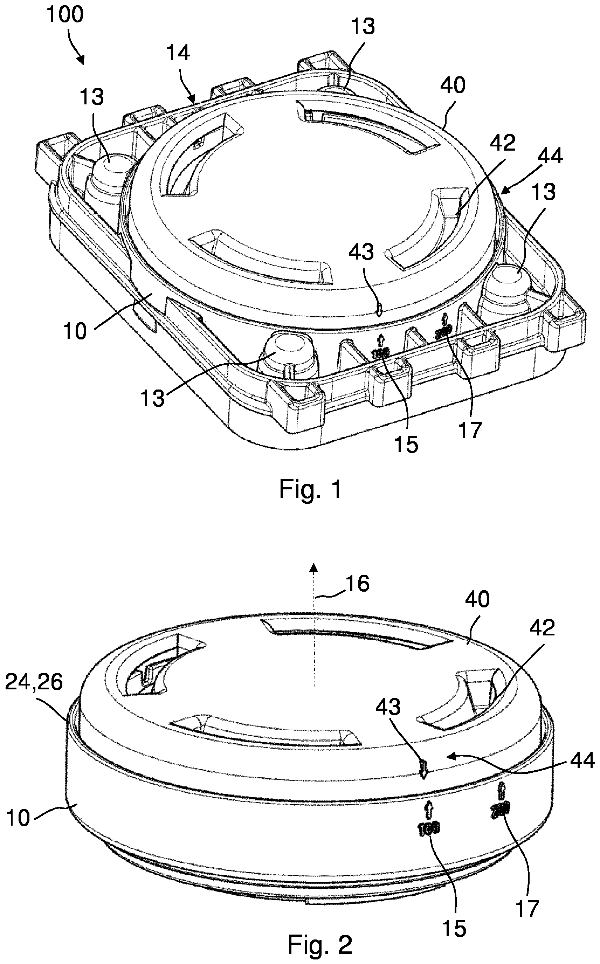

Figure 1 depicts an isometric view of a venting unit 100 for venting an electronics housing, in particular a battery housing, according to an embodiment of the invention. The venting unit 100 in an intended use is mounted above a pressure compensation opening of the electronics housing for venting. Fixing of the venting unit 100 to the electronics housing may be achieved by screws disposed in mounting domes 13 in all four corners of the venting unit 100. Four cover openings 42 for venting gas passage are disposed in the cover 40 of the venting unit 100.

In Figure 2 an isometric view of part of the venting unit 100 in a first mounting position 44 of the cover 40 is shown. In this Figure only the central part of the venting unit 100 with the base body 10 and the cover 40 is depicted. In the first mounting position 44 the venting unit 100 may be adjusted to an opening pressure of e.g. 100 mbar, which is indicated by placement of the position of the cover mark 23 relative to the marks 15, 17 on the circumference of the base body 10. Of course other values of opening pressures may be applicable depending on the area of use of the venting unit 100.

The at least two mounting positions 44, 46 may be realized as angular positions 44, 46, 48 around a central axis 16.

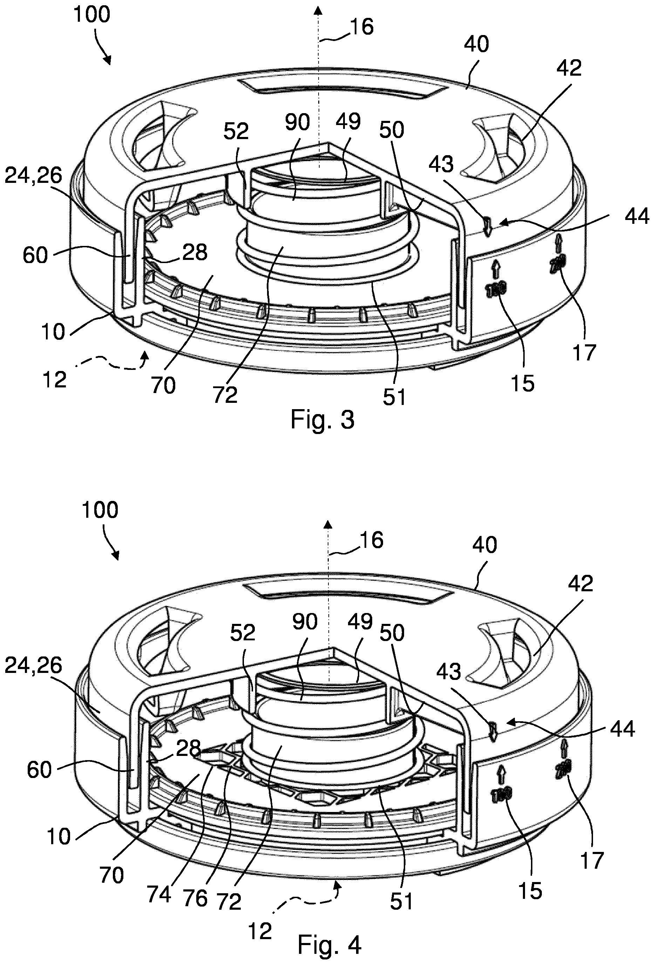

Figure 3 depicts a partly cut isometric view of the venting unit 100 in order to demonstrate the components of the venting unit 100.

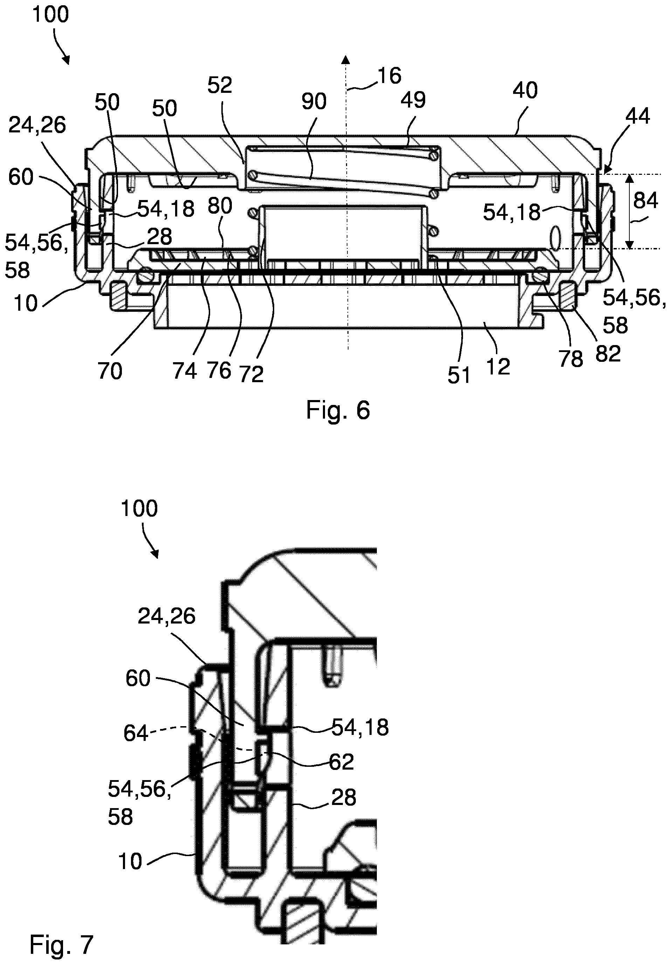

The venting unit at least comprises the base body 10 configured to be connected to the pressure compensation opening of the electronics housing, the fluid-permeable cover 40 disposed on the base body 10, a valve closure plate 70 covering an opening 12 (see the cut view in Figure 6) of the base body 10 and covered by the cover 40.

A spring member 90 is interposed between the valve closure plate 70 and the cover 40 engaging the valve closure plate 70 and the cover 40. The cover 40 has at least two mounting positions 44, 46 providing different heights 84, 86 of the cover 40 above the valve closure plate 70. A pre-compression of the spring member 90 corresponding to an opening pressure of the valve closure plate 70 is controlled by the actual mounting position of the cover 40.

One end 49 of the spring member 90 is disposed in a recess 52 disposed at an inner side 50 of the cover 40, and another end 51 of the spring member 90 is disposed on a guiding element 72 of the valve closure plate 70.

The rim 24 of the base body 10 is a circumferential groove 26. The circumference 60 of the cover 40 is received by the circumferential groove 26 in an intended mounting position.

Figure 4 depicts a partly cut isometric view of a venting unit 100 according to a further embodiment of the invention with an opening in the valve closure plate 70.

The essential design of the venting unit 100 is the same as depicted in Figure 3. The main difference is that the valve closure plate 70 has a plate opening 74 surrounding the central guiding element 72. The opening 74 is covered by a grid-like element 76. The venting unit 100 may further include a semipermeable membrane 80 covering the plate opening 74, as is to be seen in Figure 6, enabling passage of gaseous media from an environment into the electronics housing and from the electronics housing to the environment, but preventing passage of liquid media and solids.

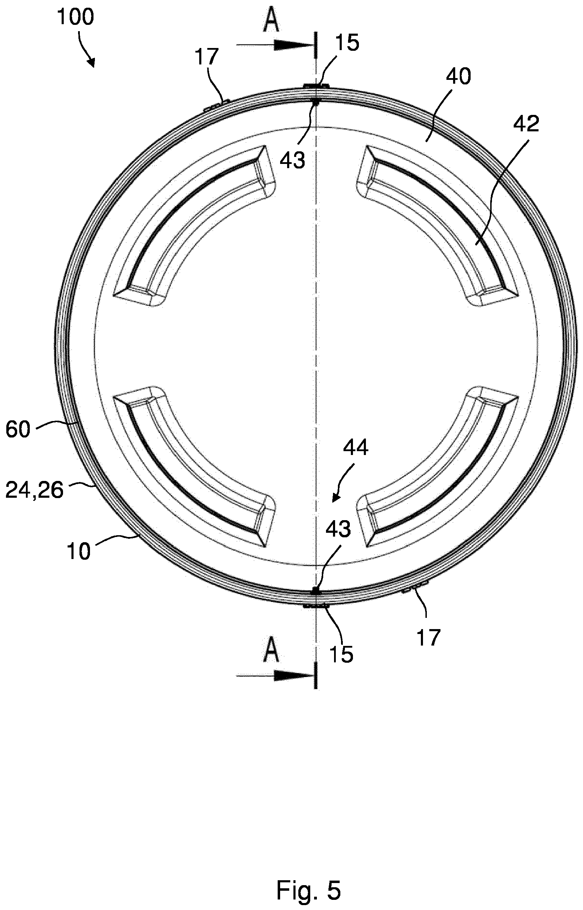

Figure 5 shows a top view of the venting unit 100 according to Figure 4. In the top view it is to be seen that the cover marks 43 as well as the marks 15, 17 on the circumference of the base plate 10 are placed symmetrically across the diameter of the venting unit 100.

Figure 6 depicts a sectional cut of the venting unit 100 according to the section plane A-A of Figure 5.

Here it is to be seen that the base body 10 of the venting unit 100 has a gas passage opening 12 which may be connected to the pressure compensation opening of the electronics housing the venting unit 100 is mounted to. The gas passage opening 12 is sealed against the pressure compensation opening of the electronics housing by circumferential sealing 82.

The valve closure plate 70 is pressed against a sealing 78 in a fluid-tight manner. The sealing 78 is disposed on a circumference of the gas passage opening 12.

The valve closure plate 70 has a plate opening 74 which is covered with the semipermeable membrane 80 for ensuring passage of gaseous media from an environment into the electronics housing and from the electronics housing to the environment, but preventing passage of liquid media and solids.

As is to be seen in Figure 6, the mounting positions 44, 46 of the cover 40 may be secured by a snap connection 54 between the cover 40 and the base body 10. The snap connection 54 comprises at least one fixing element 56 at the cover 40 counteracting with a first one and/or a second one of at least two counter elements 18, 20 at the base body 10 for fixing the cover 40 in a first one and/or a second one of the mounting positions 44, 46 at the base body 10. In Figure 6 the cover 40 is shown in the first mounting position 44 where the fixing elements 56 are connected to the counter elements 18 thus establishing a first height 84 of the cover 40 above the valve closure plate 70.

The snap connection 54 is shown in more detail in sectional view depicted in Figure 7.

The counter elements 18, 20 are disposed on an inner side 28 of the circumferential groove 26, and the fixing element 56 disposed on the circumference 60 of the cover 40 is pointing radially inwards.

The fixing element 56 may be a latching element 58 on the circumference 60 of the cover 40 and the counter elements 18, 20 may be holes 22 in a rim 24 of the base body 10.

Two fixing elements 56 are disposed across each other on the circumference 60 of the cover 40, and two counter elements 18, 20 are disposed across each other on the rim 24 of the base body 10.

The latching element 58 may e.g. comprise a pin 62 counteracting with a spring 64 supported at the circumference 60 of the cover 40. During mounting of the cover 40 the pin 62 may be pressed against the spring 64 in a radial outward direction. When the latching element 58 is positioned at the counter element 18 the pin 62 is pressed by the spring 64 into the hole 22 of the counter element 18. Thus the cover 40 is latched to the base body 10 by the snap connection 54.

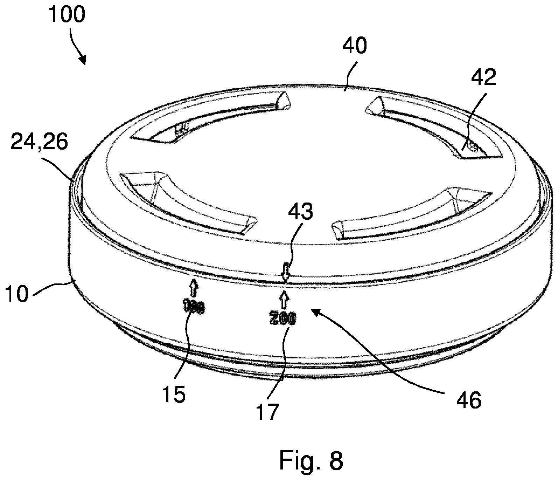

In Figure 8 an isometric view of part of the venting unit 100 is shown in a second mounting position 46 of the cover 40. Here the cover mark 43 is positioned at the second mark 17 on the circumference of the base body 10 indicating an opening pressure of e.g. 200 mbar of the valve closure plate 70.

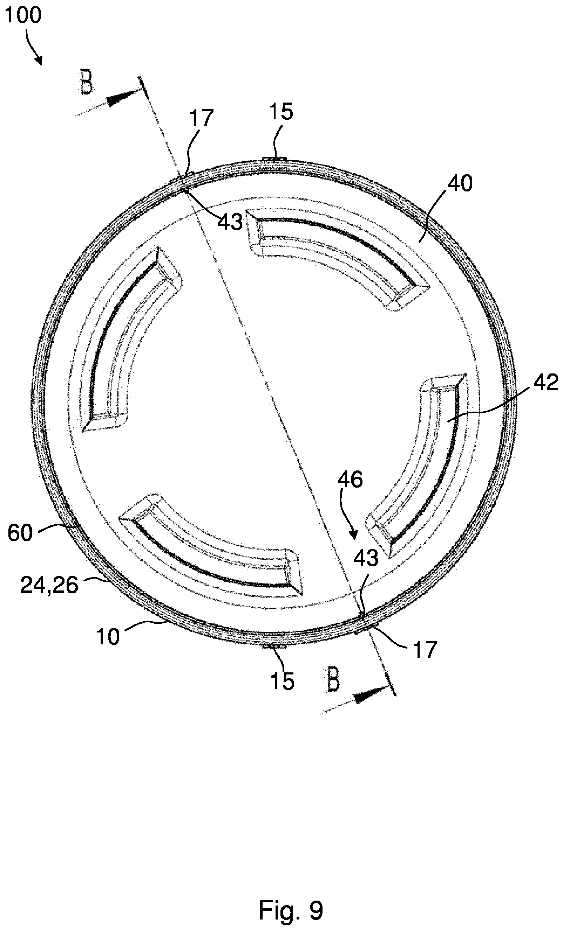

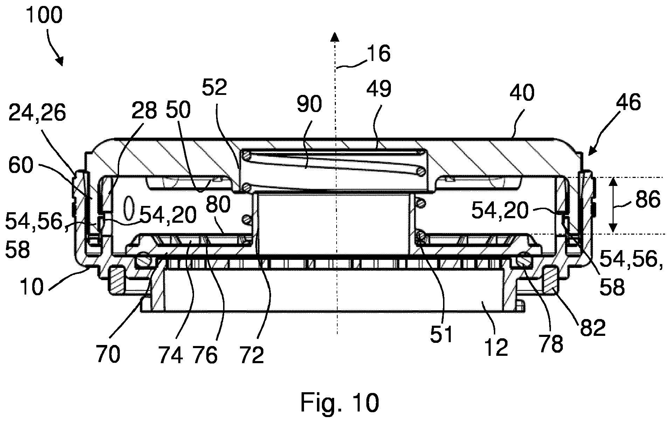

Figure 9 depicts a top view of the venting unit 100 according to Figure 8, and in Figure 10 a sectional cut of the venting unit 100 according to the section plane B-B of Figure 9 is depicted.

Here the cover 40 is disposed by the snap connection 54 in the second mounting position 46 where the fixing elements 56 are placed in the second counter elements 20. Thus the cover 40 is placed at a smaller height 86 above the valve closure plate 70 enabling a higher compression load of the spring member 90.

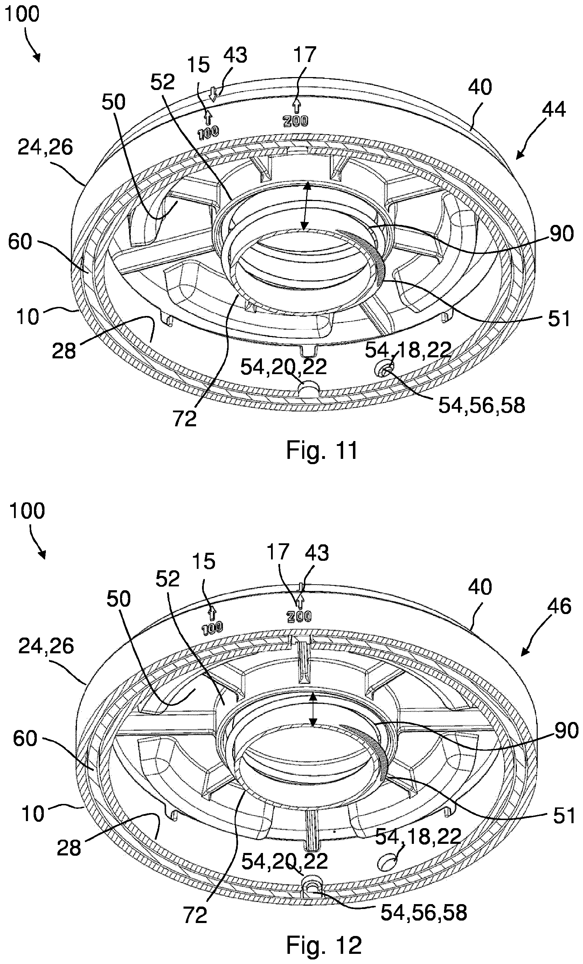

Figure 11 depicts an isometric view of the venting unit 100 with part of the base body 10 removed in the first mounting position 44 of the cover 40.

A part of an interior of the venting unit 100, mainly with an inner side 50 of the cover 40, is to be seen.

The positions of the two counter elements 18, 20 of the snap connection 54 which are realized as holes 22 placed on an inner side 28 of the circumference of the base body 10 are to be seen. The cover 40 is disposed in the first mounting position 44. Thus, the fixing element 56 is positioned in the first counter element 18.

In Figure 12 the venting unit 40 is depicted in the same view in the second mounting position 46. Here the fixing element 56 is positioned in the second counter element 20.

As can be seen by the double arrow indicated at the guiding element 72 the spring member 90 around the guiding element 72 compressed more in the mounting position 46 in Figure 12 than in the mounting position 44 in Figure 11 resulting in a higher opening pressure of the venting device 100.

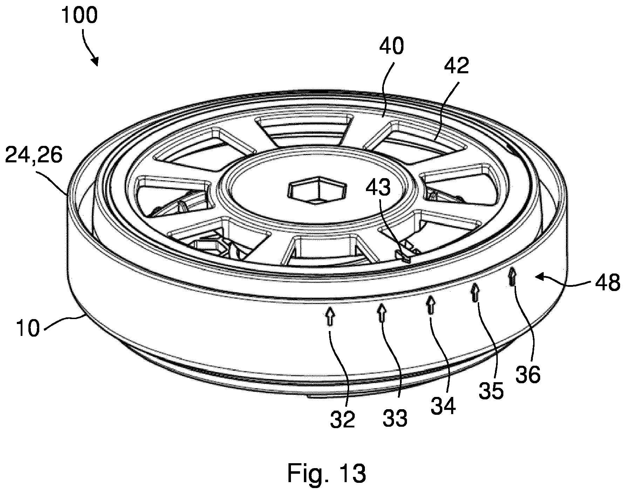

Figure 13 depicts a venting unit 100 according to a further embodiment of the invention.

In this embodiment a plurality of angular positions 48 of the cover 40 around the central axis 16 is possible indicated by the marks 32, 33, 34, 35, 36 on the circumference of the base body 10. The cover mark 43 is shown in a middle position 48 pointing to mark 34 positioned in the middle of the marks 32, 33, 34, 35, 36.

The cover 40 of this embodiment has a number of openings 42 for gas passage.

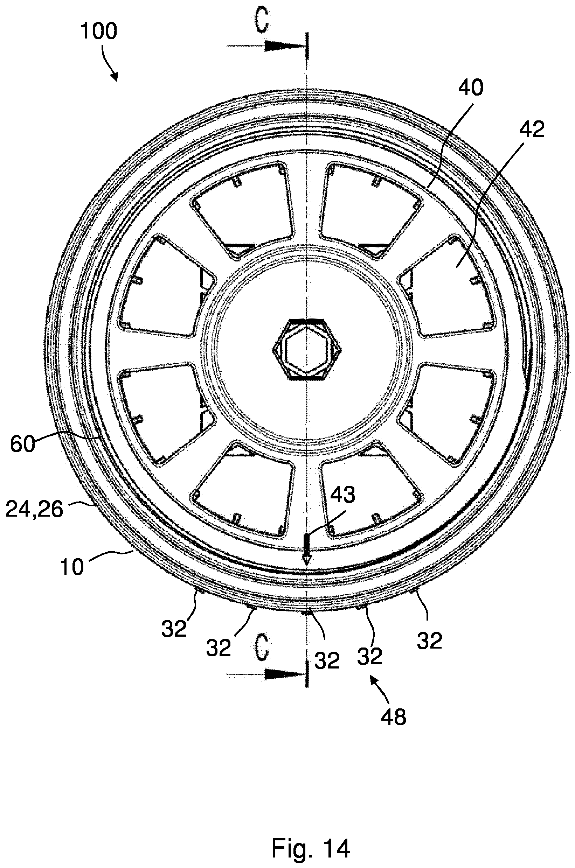

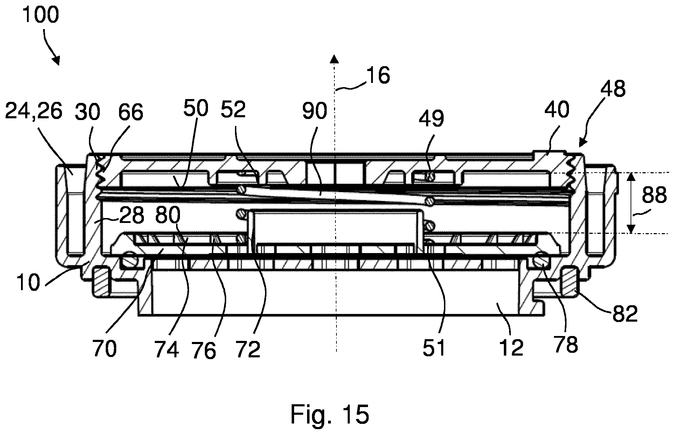

In Figure 14 a top view of the venting unit 100 according to Figure 13 is depicted, indicating a sectional plane C, whereas Figure 15 shows a sectional cut of the venting unit 100 according to the section plane C-C of Figure 14.

As is to be seen in the sectional cut, the cover 40 is connected to the base body 10 by a circumferential thread 66 counteracting with a thread engagement region 30 of a rim 24 of the base body 10.

As already shown in Figure 13, the cover 40 may be disposed in a plurality of angular positions 48 around the central axis 16. The plurality of angular positions 48 may be realized by a variation of a depth of threading the circumferential thread 66 of the cover 40 into the thread engagement region 30 of the base body 10. In the embodiment shown a height 88 is adjusted with an engagement of the thread 66 into the thread engagement region 30 of the base body 10.

After being disposed in an intended angular position 48, the cover 40 may be fixed to the base body 10. In particular, the cover 40 may be fixed to the base body 10 by a poka-yoke or any kind of fixation between the cover 40 and the rim 24 of the base body 10.

### Reference Signs List

- 10: base body
- 12: opening
- 13: mounting dome
- 15: mark
- 16: central axis
- 17: mark
- 18: counter element
- 20: counter element
- 22: hole
- 24: rim
- 26: circumferential groove
- 28: inner side
- 30: thread engagement region
- 32: mark
- 33: mark
- 34: mark
- 35: mark
- 36: mark
- 40: cover
- 42: cover opening
- 43: cover mark
- 44: mounting position
- 46: mounting position
- 48: mounting position
- 49: end
- 50: inner side
- 51: end
- 52: recess
- 54: snap connection
- 56: fixing element
- 58: latching element
- 60: circumference
- 62: pin
- 64: spring
- 66: circumferential thread
- 70: valve closure plate
- 72: guiding element
- 74: plate opening
- 76: grid-like element
- 78: sealing
- 80: semipermeable membrane
- 82: sealing
- 84: height
- 86: height
- 88: height
- 90: spring member
- 100: venting unit

## Claims

1. A venting unit (100) for venting an electronics housing, the venting unit (100) comprising
a base body (10) configured to be connected to a pressure compensation opening of the electronics housing;
a fluid-permeable cover (40) disposed on the base body (10);
a valve closure plate (70) covering an opening (12) of the base body (10) and being covered by the cover (40); and
a spring member (90) interposed between the valve closure plate (70) and the cover (40) and engaging the valve closure plate (70) and the cover (40),
wherein the cover (40) has at least two mounting positions (44, 46, 48) providing different heights (84, 86, 88) of the cover (40) above the valve closure plate (70), and
wherein a pre-compression of the spring member (90) corresponding to an opening pressure of the valve closure plate (70) is controlled by an actual mounting position of the cover (40).

2. The venting unit (100) according to claim 1, wherein the at least two mounting positions (44, 46, 48) are angular positions (44, 46, 48) around a central axis (16).

3. The venting unit (100) according to claim 1 or 2, wherein the at least two mounting positions (44, 46, 48) are secured by a snap connection (54) between the cover (40) and the base body (10).

4. The venting unit (100) according to any of the preceding claims, wherein one end (49) of the spring member (90) is disposed in a recess (52) disposed at an inner side (50) of the cover (40), and
wherein another end (51) of the spring member (90) is disposed on a guiding element (72) of the valve closure plate (70).

5. The venting unit (100) according to claim 3, wherein the snap connection (54) comprises at least one fixing element (56) at the cover (40) counteracting with a first one and/or a second one of at least two counter elements (18, 20) at the base body (10) for fixing the cover (40) in a first one and/or a second one of the at least two mounting positions (44, 46, 48) at the base body (10).

6. The venting unit (100) according to claim 5, wherein the at least one fixing element (56) is a latching element (58) disposed on a circumference (60) of the cover (40), and
wherein the at least two counter elements (18, 20) are holes (22) in a rim (24) of the base body (10).

7. The venting unit (100) according to claim 5, wherein two fixing elements (56) are disposed across each other on a circumference (60) of the cover (40), and
wherein two counter elements (18, 20) are disposed across each other on a rim (24) of the base body (10).

8. The venting unit (100) according to claim 6, wherein the latching element (58) comprises a pin (62) counteracting with a spring (64) supported at the circumference (60) of the cover (40).

9. The venting unit (100) according to any of the claims 6 to 8, wherein the rim (24) of the base body (10) is a circumferential groove (26), and
wherein the circumference (60) of the cover (40) is received by the circumferential groove (26) in an intended mounting position.

10. The venting unit (100) according to claim 9, wherein the at least two counter elements (18, 20) are disposed on an inner side (28) of the circumferential groove (26), and
wherein the fixing element (56) disposed on the circumference (60) of the cover (40) is pointing radially inwards.

11. The venting unit (100) according to claim 1 or 2, wherein the cover (40) is connected to the base body (10) by a circumferential thread (66) counteracting with a thread engagement region (30) of a rim (24) of the base body (10).

12. The venting unit (100) according to claim 11, wherein the cover (40) is disposed in a plurality of angular positions (48) around the central axis (16), and
wherein the plurality of angular positions (48) is realized by a variation of a depth of threading the circumferential thread (66) of the cover (40) into the thread engagement region (30) of the base body (10).

13. The venting unit (100) according to claim 12, wherein the cover (40) is fixed to the base body (10) after being disposed in an intended angular position (48) by a poka-yoke between the cover (40) and the rim (24) of the base body (10).

14. The venting unit (100) according to any of the preceding claims, wherein the valve closure plate (70) has at least one plate opening (74) and comprises a grid-like element (76) covering the at least one plate opening (74), and
wherein the venting unit (100) further comprises a semipermeable membrane (80) covering the at least one plate opening (74) and enabling passage of gaseous media from an environment into the electronics housing and from the electronics housing to the environment, but preventing passage of liquid media and solids.
